# EUROPEAN PATENT APPLICATION

(11) **EP 4 020 563 A1**
(43) Date of publication of application: **29.06.2022**
(21) Application number: 20216962.9
(22) Date of filing: 23.12.2020
(51) Int. Cl.: H01L 27/11556, H01L 27/11582, H01L 29/78, H01L 29/788, H01L 29/792

(54) **THREE-DIMENSIONAL SEMICONDUCTOR MEMORY DEVICE**

(71) Applicant: Fraunhofer-Gesellschaft zur Förderung der angewandten Forschung e.V., 80686 München (DE)
(72) Inventor: Nebrich, Dr. Lars, 80686 München (DE)
(74) Representative: Schlenker, Julian

(57) **Abstract**

Embodiments provide a three-dimensional semiconductor memory device comprising a plurality of stacked memory cells, wherein the plurality of stacked memory cells comprise a common channel, wherein the channel comprises a first layer of a semiconductor material and a second layer formed on the first layer, wherein the second layer is adapted to apply a mechanical stress on the first layer.

## Description

Embodiments relate to a three-dimensional semiconductor memory device. Further embodiments relate to a method for manufacturing a three-dimensional semiconductor memory device. Some embodiments relate to a silicon-silicon/germanium-channel (Si-SiGe-channel).

In three-dimensional (e.g., vertical) NAND flash memory devices, by reducing the size of the stack and increasing the length of the silicon channel for the cascaded memory cells, the speed of the entire memory device is limited by the mobility, which is possible in terms of physics, of the electrons in this channel [1].

Conventionally, the channel in three-dimensional NAND flash memory devices is manufactured out of poly silicon.

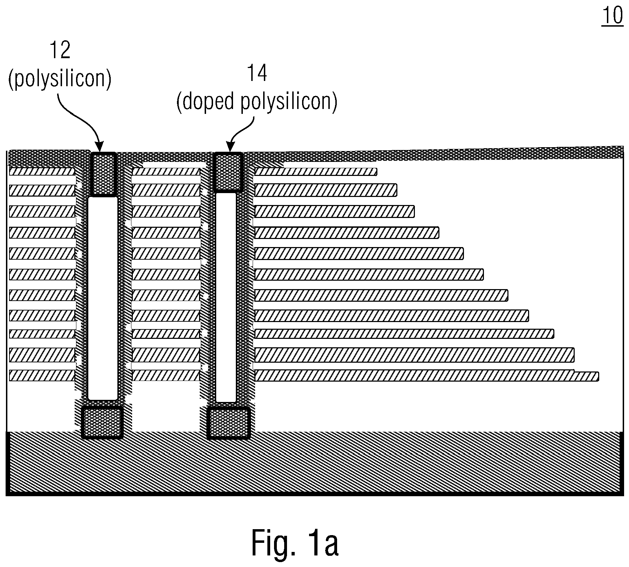

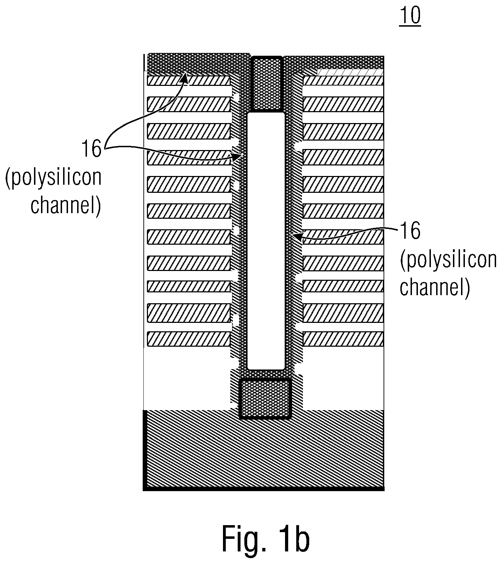

Fig. 1 shows schematic cross-sectional views of three-dimensional NAND flash memory devices 10 with conventional poly silicon channels [1]. Specifically, Fig. 1a shows that channel 12 is made out of poly silicon and that contact region 14 is made out of doped poly silicon, where Fig. 1b shows that the channel 16 is also made of poly silicon.
In [2], a process for manufacturing a three-dimensional NAND flash memory device is described.
In [3], a process integration of infrared-sensitive PIN photodiodes and CMOS transistors in a single-SiGe substrate is described.
In [4], a method of fabricating a three-dimensional semiconductor memory device is described. The method includes alternately and repeatedly stacking sacrificial layers and insulating layers on a substrate, forming an active pattern penetrating the sacrificial layers and the insulating layers, continuously patterning the insulating layers and the sacrificial layers to form a trench, removing the sacrificial layers exposed in the trench to form recess regions exposing a sidewall of the active pattern, forming an information storage layer on the substrate, forming a gate conductive layer on the information storage layer, such that the gate conductive layer fills the recess regions and defines an empty region in the trench, the empty region being surrounded by the gate conductive layer, and performing an isotropic etch process with respect to the gate conductive layer to form gate electrodes in the recess regions, such that the gate electrodes are separated from each other.
In [5], a semiconductor device is described. The semiconductor device includes a substrate, a plurality of word lines spaced apart from each other in a first direction on the substrate, a channel layer in a channel hole defined by the plurality of word lines, a gate insulating layer in the channel hole along an inner wall of the channel hole; and a self-aligned contact on an upper portion of the channel layer in the channel hole. The gate insulating layer is between the plurality of word lines and the channel layer. The first direction is perpendicular to an upper surface of the substrate. The channel hole exposes the upper surface of the substrate.
In [6], apparatuses having a source material, a dielectric material over the source material, a select gate material over the dielectric material, a memory cell stack over the select gate material, a conductive plug located in an opening of the dielectric material and contacting a portion of the source material, and a channel material extending through the memory cell stack and the select gate material and contacting the conductive plug are described.

As indicated above, the speed of a semiconductor memory device is limited by the mobility of the electrons in the poly silicon channel.

Therefore, it is the object of the present invention to provide a concept that allows increasing the speed of a semiconductor memory device.

This object is solved by the independent claims.

Advantageous implementations are addressed in the dependent claims.

Embodiments provide a three-dimensional semiconductor memory device comprising a plurality of [e.g., vertically] stacked memory cells [e.g., floating gate transistor memory cells or charge trapping memory cells], wherein the plurality of stacked memory cells comprise a common [e.g., vertical] channel, wherein the channel comprises a first layer of a semiconductor material [e.g., Si layer; e.g., poly Si layer] and a second layer [e.g., SiGe layer] formed on the first layer, wherein the second layer is adapted to apply a mechanical stress [e.g., tensile strain] on the first layer.

In embodiments, the first layer of the channel is formed on an [e.g., vertical] insulating layer [e.g., SiO2, Al2O3, high K, ONO] [e.g., of a memory/information storage layer stack [e.g., ONO, poly silicon]] of the stacked memory cells.

In embodiments, the second layer is directly formed and mechanically connected to the first layer.

In embodiments, the first layer comprises silicon, Si.

In embodiments, the second layer is a silicon compatible layer.

In embodiments, the second layer comprises silicon-germanium, SiGe.

In embodiments, the three-dimensional semiconductor memory device is three-dimensional [e.g., vertical] NAND memory device.

Further embodiments provide a method for manufacturing a three-dimensional semiconductor memory device. The method comprises a step of providing a memory device layer stack comprising a semiconductor substrate, sacrificial layers [e.g., SiN or poly silicon] and dielectric layers [e.g., oxide], wherein the sacrificial layers and the dielectric layers are alternately and repeatedly stacked on the semiconductor substrate. Further, the method comprises a step of patterning the sacrificial layers and the dielectric layers to form at least one [e.g., vertical] channel opening [e.g., hole; having a hole shape] [e.g., in which the semiconductor substrate or a layer covering the semiconductor substrate, such as an etch stop layer is exposed]. Further, the method comprises a step of forming at least an [e.g., vertical] insulating layer [e.g., SiO2, AlO3, high K or ONO] [e.g., of a [e.g., vertical] memory/information storage layer stack] in the channel opening [e.g., on sidewalls of the channel opening or on previously formed layers of a memory/information storage layer stack]. Further, the method comprises a step of forming a first [e.g., vertical] layer of a semiconductor material [e.g., Si layer; e.g., poly Si layer] [e.g., directly] on the insulating layer. Further, the method comprises a step of forming a second [e.g., vertical] layer [e.g., SiGe layer] on the first layer, wherein the second layer is adapted to apply a mechanical stress [e.g., tensile strain] on the first layer.

In embodiments the first layer is formed on the insulating layer by means of a deposition technique [e.g., CVD or ALD].

In embodiments, the second layer is formed on the first layer by means of a deposition technique [e.g., CVD or ALD].

In embodiments, forming at least an [e.g., vertical] insulating layer in the channel opening includes forming an information storage layer stack in the channel opening, the information layer stack comprising the insulating layer.

For example, the information storage layer stack can comprise a second insulating layer [e.g., SiO2, Al2O3, high K, or ONO], an information storage layer [e.g., floating gate layer or charge trapping layer] [e.g., poly silicon or SiN], and the (first) insulating layer [e.g., tunnel insulating layer or blocking insulating layer] [e.g., SiO2, AlO3, high K, or ONO].

In embodiments, the insulating layer is a first insulating layer, wherein the information storage layer stack is formed by: selectively removing portions of the sacrificial layers [e.g., poly silicon] while maintaining the dielectric layers, to form recesses; forming a second insulating layer [e.g., SiO2, Al2O3, high K, ONO] in the recesses; forming an information storage layer [e.g., floating gate layer] [e.g., poly silicon] on the second insulating layer; and forming the first insulating layer [e.g., tunnel insulating layer] [e.g., SiO2, Al2O3, high K, ONO] on the information storage layer.

In embodiments, the method further comprises: patterning the sacrificial layers and the insulating layers to form trenches [e.g., in which the semiconductor substrate or an insulating layer on the substrate is exposed]; selectively removing the sacrificial layers while maintaining the dielectric layers, to form recesses exposing some portions of the information storage layer stack [e.g., the second insulating layer of the information storage layer stack]; and forming a gate layer [e.g., poly silicon or metal, such as tungsten] in the recesses, such that the gate layer contacts the information storage layer stack [e.g., the second insulating layer of the information storage layer stack].

In embodiments, forming at least an [e.g., vertical] insulating layer in the channel comprises forming the insulating layer [e.g., SiO2, Al2O3, high K, ONO] on the sidewalls of the channel opening.

In embodiments, forming at least an [e.g., vertical] insulating layer in the channel comprises forming an information storage layer stack on sidewalls of the channel opening, the information layer stack comprising the insulating layer.

For example, the information storage layer stack can comprise a second insulating layer [e.g., SiO2, Al2O3, high K, or ONO], an information storage layer [e.g., charge trapping layer] [e.g., SiN], and the (first) insulating layer [e.g., blocking insulating layer] [e.g., SiO2, AlO3, high K, or ONO].

In embodiments, the insulating layer is a first insulating layer, wherein the method further comprises: forming a second insulating layer [e.g., SiO2, Al2O3, high K, ONO] on sidewalls of the of the channel opening; forming an information storage layer [e.g., charge trap layer] [e.g., or silicon nitride] on the second insulating layer [e.g., SiO2, Al2O3, high K, ONO]; forming a first insulating layer [e.g., SiO2, Al2O3, high K, ONO] on the information storage layer.

In embodiments, the method further comprises: patterning the sacrificial layers and the dielectric layers to form trenches [e.g., in which the semiconductor substrate or an insulating layer on the substrate is exposed]; selectively removing the sacrificial layers while maintaining the dielectric layers, to form recesses exposing some portions of the second insulating layer; forming a gate layer [e.g., poly silicon or metal, such as tungsten] in the recesses, such that the gate layer contacts the information storage layer stack [e.g., the second insulating layer of the information storage layer stack].

In embodiments, the method further comprises: filling the channel opening after forming the first layer and the second layer with an isolating material.

Embodiments provide three-dimensional NAND memory cells, wherein conducting tracks within the semiconductor memory comprise (e.g., consist) of at least one silicon layer that is in direct mechanical contact with a layer containing silicon-germanium.

Embodiments allow for increasing the mobility of the electrons in the channel of the memory cell area. Thereby, the overall speed of accessing the memory cells is increased.

Embodiments of the present invention are described herein making reference to the appended drawings.
- Figs. 1a-b: shows schematic cross-sectional views of three-dimensional NAND flash memory devices with conventional poly silicon channels,
- Fig. 2: shows a schematic cross-sectional view of a three-dimensional semiconductor memory device, according to an embodiment of the present invention,

- Fig. 3: shows a schematic cross-sectional view of a three-dimensional NAND flash memory device with doped polysilicon layer in the channel area of the memory device followed by a polysilicon-germanium layer, according to an embodiment,
- Fig. 4: shows a flow chart of a method for manufacturing a three-dimensional memory device, according to an embodiment of the present invention,
- Figs. 5a-m: cross-sectional views of the three-dimensional memory device after different steps of a first embodiment of the method for manufacturing a three-dimensional memory device of Fig. 4, and
- Figs. 6a-h: cross-sectional views of the three-dimensional memory device after different steps of a second embodiment of the method for manufacturing a three-dimensional memory device of Fig. 4.

Equal or equivalent elements or elements with equal or equivalent functionality are denoted in the following description by equal or equivalent reference numerals.

In the following description, a plurality of details are set forth to provide a more thorough explanation of embodiments of the present invention. However, it will be apparent to one skilled in the art that embodiments of the present invention may be practiced without these specific details. In other instances, well-known structures and devices are shown in block diagram form rather than in detail in order to avoid obscuring embodiments of the present invention. In addition, features of the different embodiments described hereinafter may be combined with each other, unless specifically noted otherwise.

Subsequently, further embodiments of the present invention are described, which can be implemented individually or in combination with any of the embodiments described herein.

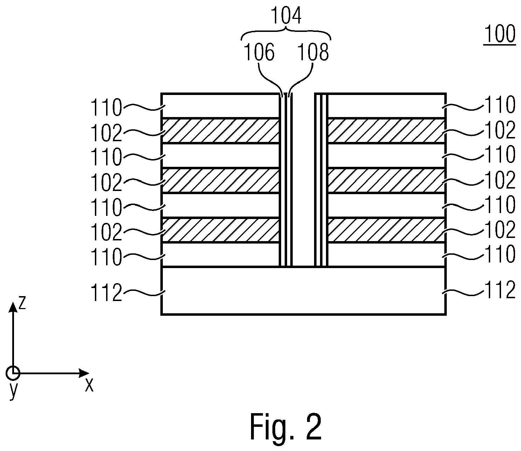

Fig. 2 shows a schematic cross-sectional view of a three-dimensional semiconductor memory device 100, according to an embodiment of the present invention. The three-dimensional semiconductor memory device 100 comprises a plurality of (e.g., vertically) stacked memory cells 102, wherein the plurality of stacked memory cells 102 comprise a common (e.g., vertical) channel 104, wherein the channel 104 comprises a first layer 106 of a semiconductor material and a second layer 108 formed on the first layer 106, wherein the second layer 108 is adapted to apply a mechanical stress (e.g., tensile strain) on the first layer 106.

In embodiments, the first layer 106 of the channel 104 is formed (e.g., directly) on an insulating layer of the plurality of (e.g., vertically) stacked memory cells 102. The insulating layer can be, for example, a SiO2 (silicon oxide), Al2O3 (aluminum oxide), high K (a material with a high dielectric constant as compared to silicon dioxide) or ONO (oxide-nitrid-oxide) layer. The insulating layer can be, for example, part of a memory/information storage layer stack of the plurality of (e.g., vertically) stacked memory cells 102.

In embodiments, the second layer 108 is directly formed and mechanically connected to the first layer 106, e.g., in order to apply a mechanical stress (e.g., tensile strain) on the first layer 106.

In embodiments, the first layer 106 comprises Si (silicon). For example, the first layer 106 can be a Si or poly Si layer.

In embodiment, the second layer 108 is a silicon compatible layer. For example, the second layer 108 can be a silicon-germanium (SiGe) layer.

In embodiments, the three-dimensional semiconductor memory device 100 is a three-dimensional (e.g., vertical) NAND memory device.

In embodiments, the plurality of (e.g., vertically) stacked memory cells 102 can be floating gate transistor memory cells or charge trapping memory cells.

As shown in Fig. 2 by way of example, the plurality of memory cells 102 can be alternately stacked with dielectric layers 110 in between the different memory cells 102 on a (e.g., semiconductor) substrate 112.

Note that in Fig. 2, for simplicity reasons, only the basic layer stack of the memory cells 102 of the three-dimensional semiconductor memory device 100 is shown. Naturally, the three-dimensional semiconductor memory device 100 can comprise further functional layers and structures not shown in Fig. 2, such as further isolating layers, etch stop layers, conductive plugs, select gates, etc., which are known to a man of ordinary skill in the art [4], [5], [6].

As already mentioned, the memory cells 102 are stacked in a vertical direction. For illustration purposes, Fig. 2 shows a Cartesian coordinate system, with a x-axis, a y-axis and a z-axis perpendicular to each other, wherein the x-axis and the y-axis span a plane parallel to surface of the semiconductor substrate, and wherein the z-axis is perpendicular to the surface of the semiconductor substrate. Thereby, the vertical direction extends parallel to the z-axis, wherein a lateral direction extends parallel to the plane spanned by the x-axis and the y-axis.

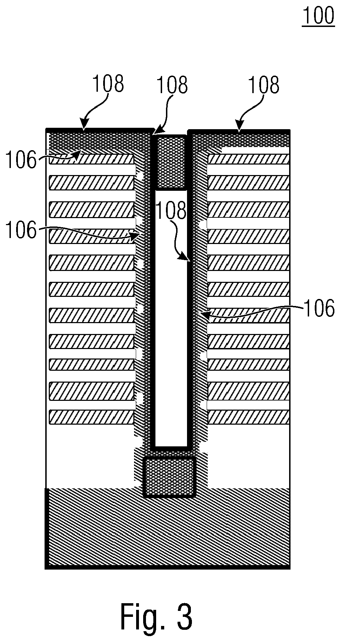

In accordance with embodiments, manufacturing of a layer system of a first layer 106 and a second layer 108 that is adapted to apply a mechanical stress (e.g., tensile strain) on the first layer 106, e.g., a layer system of thin silicon on a crystalline silicon-germanium layer, results in clearly increased mobility of the electrons in the channel area of an NMOS transistor due to straining of the thin silicon layer. Deposition of a doped polysilicon layer in the channel area of the memory device indicated in Fig. 3, followed by a polysilicon-germanium layer, results in increased mobility of the electrons in the silicon layer and, thus, in increased speed of the memory cell area.

Fig. 3 shows a schematic cross-sectional view of a three-dimensional NAND flash memory device 100 with doped polysilicon layer 106 in the channel area of the memory device followed by a polysilicon-germanium layer 108, according to an embodiment. In other words, Fig. 3 shows silicon-silicon/germanium in the channel of a 3D NAND flash memory chip.

Actual three-dimensional NAND flash cell structures are based on two main principles: First, a floating-gate cell with information storage via electrons on a fully isolated gate electrode, and second, a SONOS (silicon-oxide-nitride-oxide-silicon) cell concept with information storage via electrons in an oxide-nitride interface. Both cell concepts use a doped poly-silicon layer as channel for every cell-transistor in the vertical memory block. The electron mobility and therefore the overall speed especially for reading is limited depending on the doping, grain size and intrinsic physical properties of the silicon material. The interface to the silicon channel is realized by a thin oxide-nitrid-oxide-layer (ONO).

In accordance with embodiments, the intrinsic properties of the silicon material in the channel is improved by applying mechanical stress with a silicon compatible material like SiGe.

Silicon is used as first layer to have good electrical interface properties to the ONO-layer dielectric towards the memory cell structure. The SiGe layer is used as second layer to apply tensile strain to the silicon layer due to the bigger lattice constant in the poly-silicon grains. The applied strain leads to a higher intrinsic electron mobility in the silicon layer and therefore to a higher speed of the memory performance.

The poly silicon layers may be deposited by chemical vapor deposition (CVD) or atomic layer deposition (ALD) into the memory cell trench after deposition of insulation layers SiO2 (silicon oxide), Al2O3 (aluminum oxide), high K or ONO (oxide-nitride-oxide).

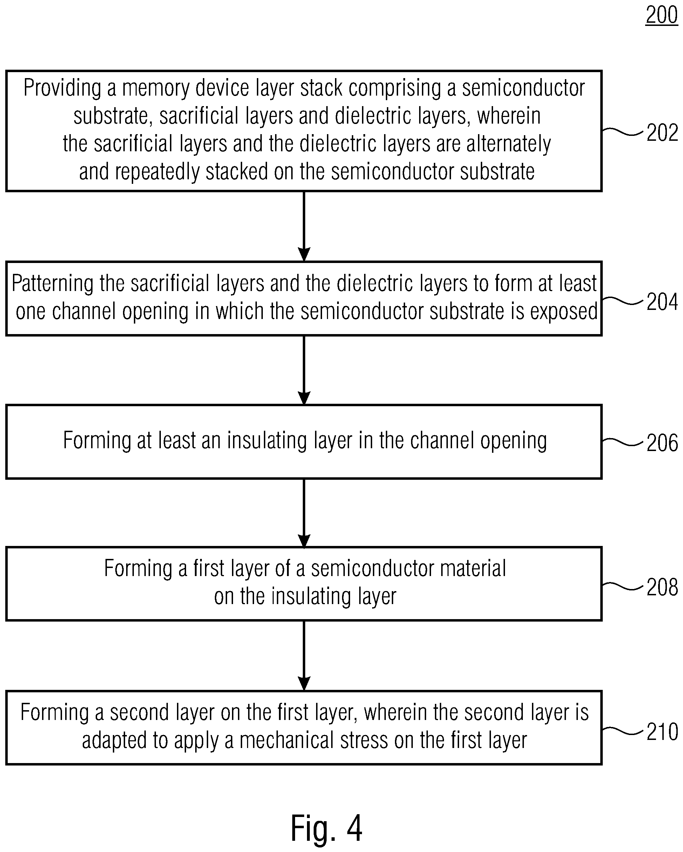

Subsequently, a method for manufacturing a three-dimensional semiconductor memory device with a channel comprising a first layer of a semiconductor material (e.g., Si or poly Si) and a second layer (e.g., SiGe) for applying a mechanical stress (e.g., tensile strain) on the first layer will be described with respect to Figs. 4 to 6h.

Fig. 4 shows a flow chart of a method 200 for manufacturing a three-dimensional memory device, according to an embodiment of the present invention. The method 200 comprises a step 202 of providing a memory device layer stack comprising a semiconductor substrate, sacrificial layers and dielectric layers, wherein the sacrificial layers and the dielectric layers are alternately and repeatedly stacked on the semiconductor substrate. Further, the method 200 comprises a step 204 of patterning the sacrificial layers and the dielectric layers to form at least one channel opening in which the semiconductor substrate is exposed. Further, the method 200 comprises a step 206 of forming at least an insulating layer in the channel opening. Further, the method 200 comprises a step 208 of forming a first layer of a semiconductor material on the insulating layer. Further, the method 200 comprises a step 210 of forming a second layer on the first layer, wherein the second layer is adapted to apply a mechanical stress on the first layer.

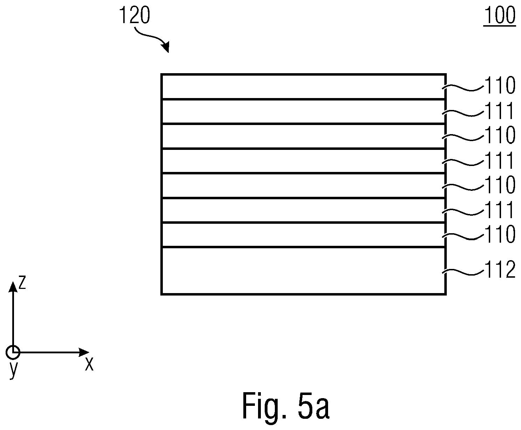

In the following, embodiments of the method 200 for manufacturing a three-dimensional memory device will be described making reference to Figs. 5a to 6h, which show cross-sectional views of the three-dimensional memory device after different manufacturing steps.

Note that in Figs. 5a to 6h, for simplicity reasons, only the basic layer stack of the memory cells 102 of the three-dimensional semiconductor memory device 100 is shown. Naturally, the three-dimensional semiconductor memory device 100 can comprise further functional layers and structures not shown in the Figs, which are however known to a man of ordinary skill in the art [4], [5], [6].

Fig. 5a shows a schematic cross sectional view of the three-dimensional memory device 100 after the step 202 of providing a memory device layer stack 120 comprising a semiconductor substrate 112, sacrificial layers 111 and dielectric layers 110, wherein the sacrificial layers 111 and the dielectric layers 110 are alternately and repeatedly stacked (e.g., in a vertical direction, i.e. z-direction) on the semiconductor substrate 112.

For example, the semiconductor substrate 112 can be a silicon substrate. For example, the dielectric layers 110 can comprise or consist of oxide. For example, the sacrificial layers can comprise or consist of SiN (silicon nitride) or poly silicon.

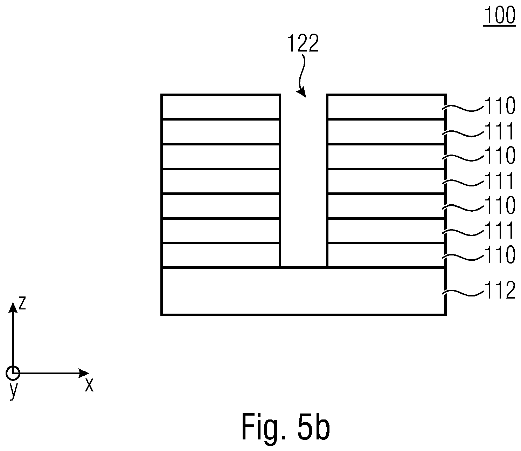

Fig. 5b shows a schematic cross sectional view of the three-dimensional memory device 100 after the step 204 of patterning the sacrificial layers 111 and the dielectric layers 110 to form at least one (e.g., vertical) channel opening 122 in which the semiconductor substrate 110 or a layer covering the semiconductor substrate 110, such as an etch stop layer (not shown in Fig. 5b), is exposed.

For example, the channel opening 122 can be a hole or have a hole shape.

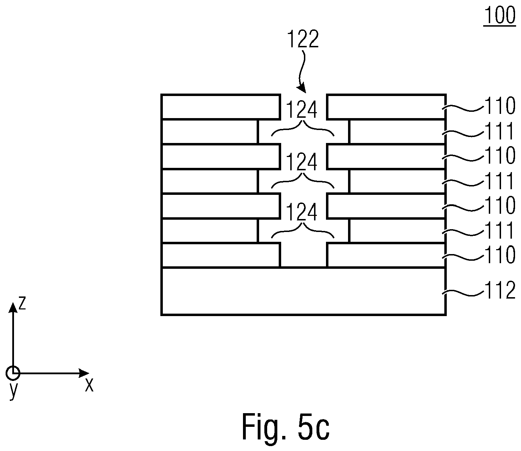

Fig. 5c shows a schematic cross sectional view of the three-dimensional memory device 100 after a step of selectively removing portions of the sacrificial layers 111 while maintaining the dielectric layers 110, to form recesses 124.

For example, the portions of the sacrificial layers 111 can be removed by means of an etch process, e.g., selective to the sacrificial layers 111. For instance, a wet etch process can be used: an isotropic etch in a lateral direction with high selectivity.

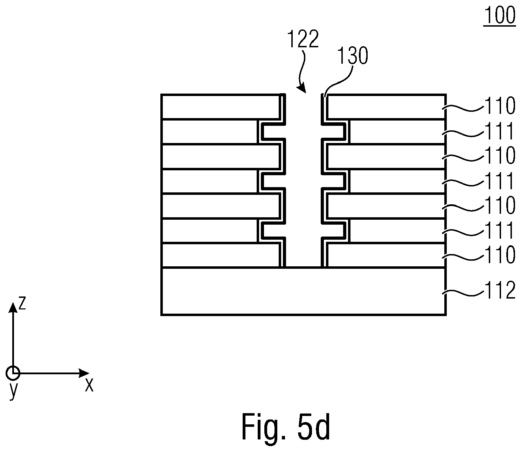

Fig. 5d shows a schematic cross sectional view of the three-dimensional memory device 100 after a step of forming a second insulating layer 130 in the recesses 124 (cf. Fig. 5c).

For example, the second insulating layer 130 can comprise or consist of SiO2 (silicon oxide), Al2O3 (aluminum oxide), high K or ONO (oxide-nitride-oxide).

For example, the second insulating layer 130 can be formed by means of a deposition technique, such as CVD (chemical vapor deposition) or ALD (atomic layer deposition).

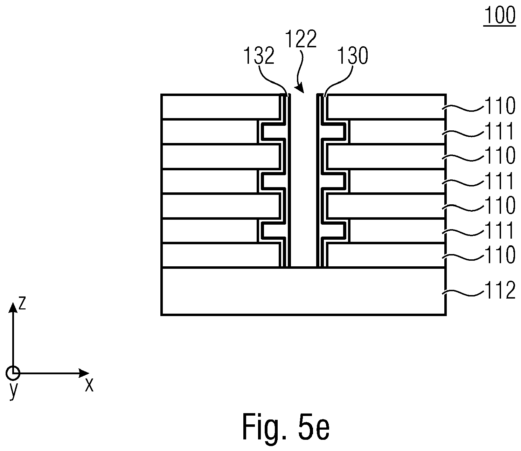

Fig. 5e shows a schematic cross sectional view of the three-dimensional memory device 100 after a step of forming an information storage layer 132 on the second insulating layer 130.

For example, the information storage layer 132 can be a floating gate layer. For example, the information storage layer 132 can comprise or consist of poly silicon.

For example, the information storage layer 132 can be formed by means of a deposition technique, such as CVD (chemical vapor deposition) or ALD (atomic layer deposition).

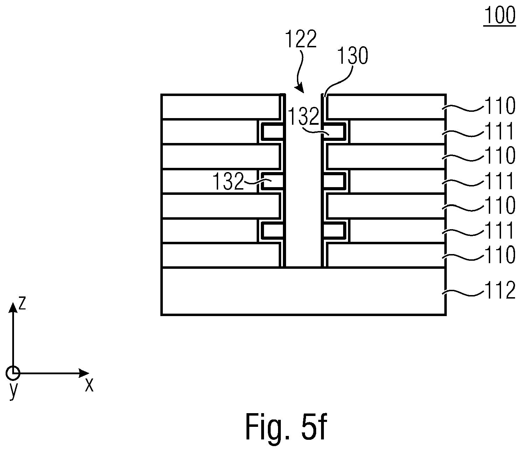

Fig. 5f shows schematic cross sectional view of the three-dimensional memory device 100 after a step of selectively removing the information storage layer 132 up to the second insulating layer 130.

For example, the information storage layer 132 can be selectively removed by means of an etch process.

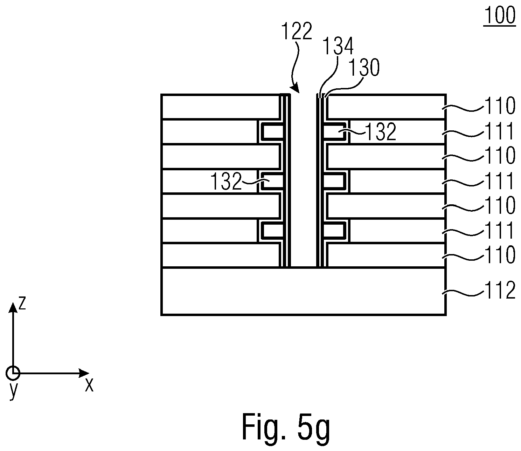

Fig. 5g shows schematic cross sectional view of the three-dimensional memory device 100 after a step of forming first insulating layer 134 on the (structured) information storage layer 132.

For example, the first insulating layer 134 can be a tunnel insulating layer. For example, the first insulating layer 134 can comprise or consist of SiO2 (silicon dioxide), Al2O3 (aluminum oxide), high K or ONO (oxide-nitride-oxide).

For example, the first insulating layer 134 can be formed by means of a deposition technique, such as CVD (chemical vapor deposition) or ALD (atomic layer deposition).

The first insulating layer 134, the information storage layer 132, and the second insulating layer 130 can form an information storage/memory layer stack.

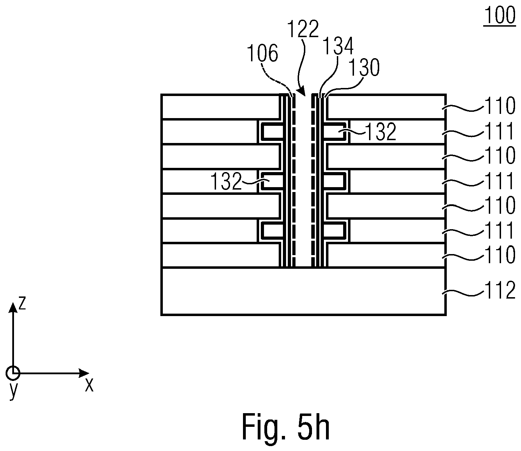

Fig. 5h shows a schematic cross sectional view of the three-dimensional memory device 100 after the step 208 of forming a first (e.g., vertical) layer 106 of a semiconductor material on the first insulating layer 134.

In embodiments, the first layer 106 can comprise or consist of Si or poly Si.

In embodiments, the first layer 106 can be formed directly on the first insulating layer 134.

In embodiments, the first layer 106 can be formed by means of a deposition technique, such as CVD (chemical vapor deposition) or ALD (atomic layer deposition).

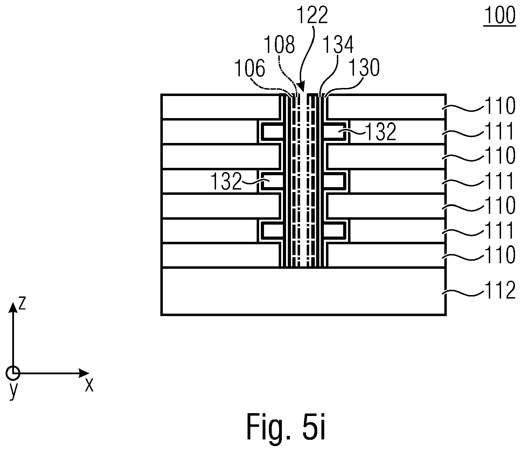

Fig. 5i shows a schematic cross sectional view of the three-dimensional memory device 100 after the step 210 of forming a (e.g., vertical) second layer 108 on the first layer 106, wherein the second layer 108 is adapted to apply a mechanical stress (e.g., tensile strain) on the first layer 106.

In embodiments, the second layer 108 can comprise or consist of SiGe (silicon germanium).

In embodiments, the second layer 108 can be formed by means of a deposition technique, such as CVD (chemical vapor deposition) or ALD (atomic layer deposition).

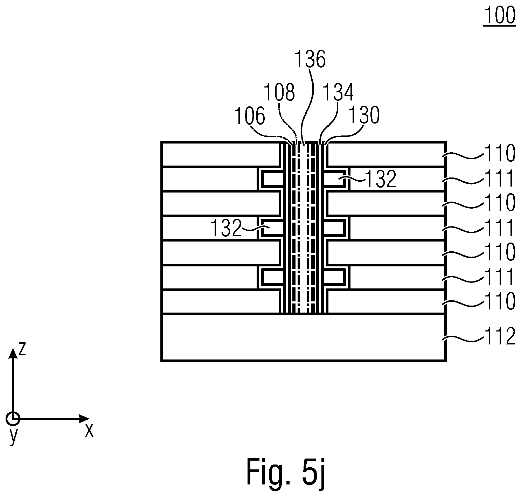

Fig. 5j shows a schematic cross sectional view of the three-dimensional memory device 100 after a step of filling the channel opening an isolating material 136.

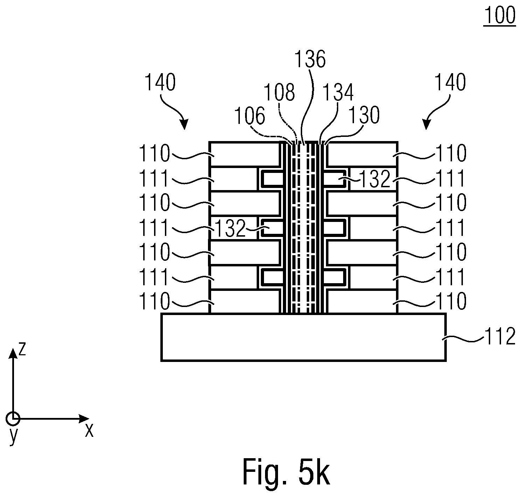

Fig. 5k shows a schematic cross sectional view of the three-dimensional memory device 100 after a step patterning the sacrificial layers 111 and the dielectric layers 110 to form trenches 140, e.g., in which the semiconductor substrate or an insulating layer / etch stop layer on the substrate 112 is exposed.

Fig. 5I shows a schematic cross sectional view of the three-dimensional memory device 100 after a step of selectively removing the sacrificial layers 111 while maintaining the dielectric layers 110, to form recesses 142 exposing some portions of the second insulating layer 130.

For example, the sacrificial layers 111 can be selectively removed by means of an etch process, e.g., selective to the sacrificial layers 111.

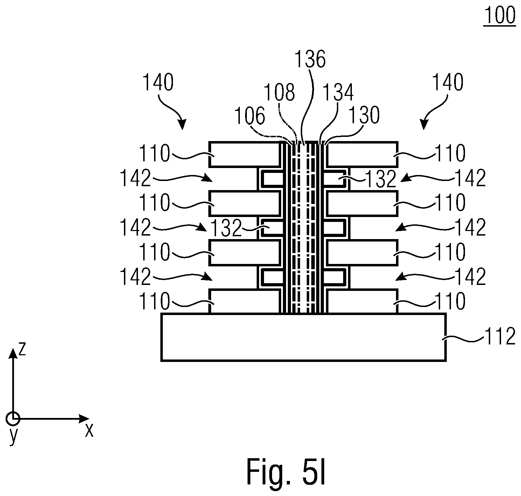

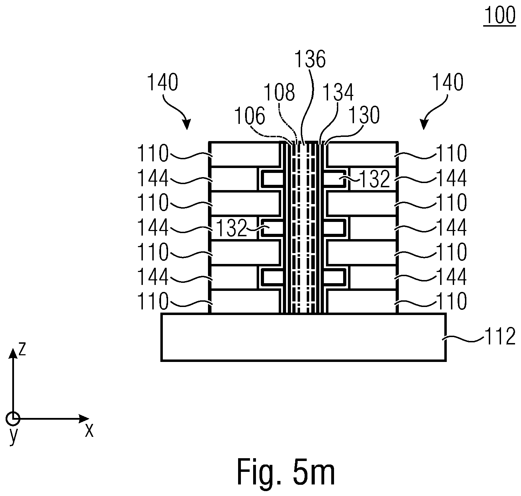

Fig. 5m shows a schematic cross sectional view of the three-dimensional memory device 100 after a step forming a gate layer 144 in the recesses 142 (cf. Fig. 5l), such that the gate layer 144 contacts the second insulating layer 130.

For example, the gate layer 144 can comprise or consist of poly silicon or metal, such as tungsten.

For example, the gate layer 144 may be formed by means of a deposition technique, such as CVD (chemical vapor deposition) or ALD (atomic layer deposition).

For example, the gate layer 144 may act as a control gate or word line.

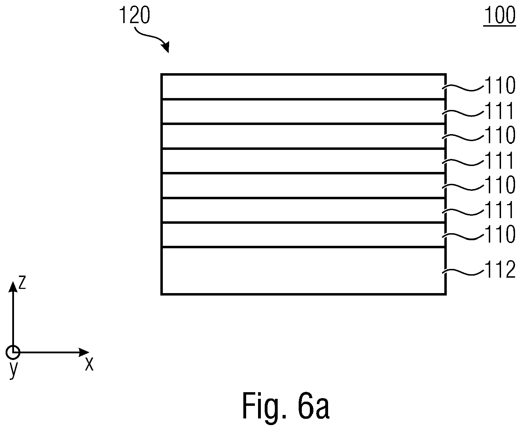

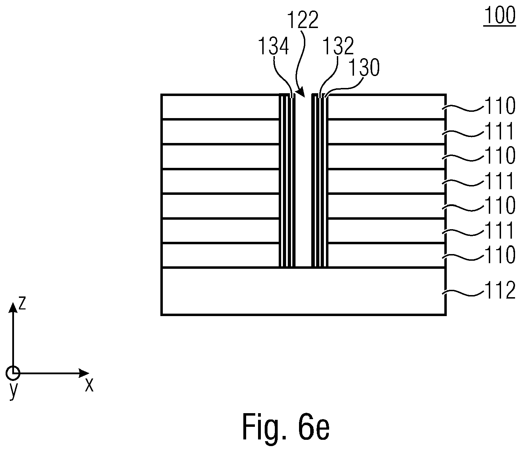

Fig. 6a shows a schematic cross sectional view of the three-dimensional memory device 100 after the step 202 of providing a memory device layer stack 120 comprising a semiconductor substrate 112, sacrificial layers 111 and dielectric layers 110, wherein the sacrificial layers 111 and the dielectric layers 110 are alternately and repeatedly stacked (e.g., in a vertical direction, i.e. z-direction) on the semiconductor substrate 112.

For example, the semiconductor substrate 112 can be a silicon substrate. For example, the dielectric layers 110 can comprise or consist of oxide. For example, the sacrificial layers can comprise or consist of SiN (silicon nitride) or poly silicon.

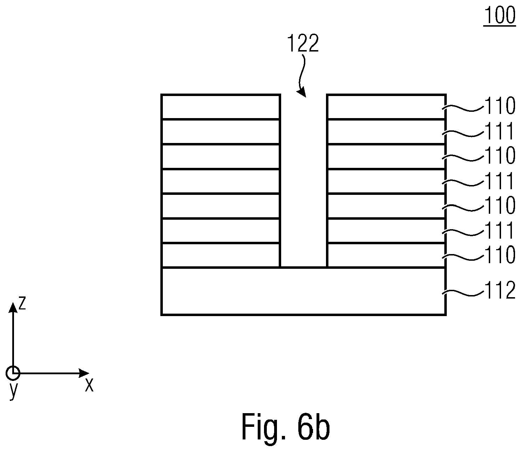

Fig. 6b shows a schematic cross sectional view of the three-dimensional memory device 100 after the step 204 of patterning the sacrificial layers 111 and the dielectric layers 110 to form at least one (e.g., vertical) channel opening 122 in which the semiconductor substrate 110 or a layer covering the semiconductor substrate 110, such as an etch stop layer (not shown in Fig. 5b), is exposed.

For example, the channel opening 122 can be a hole or have a hole shape.

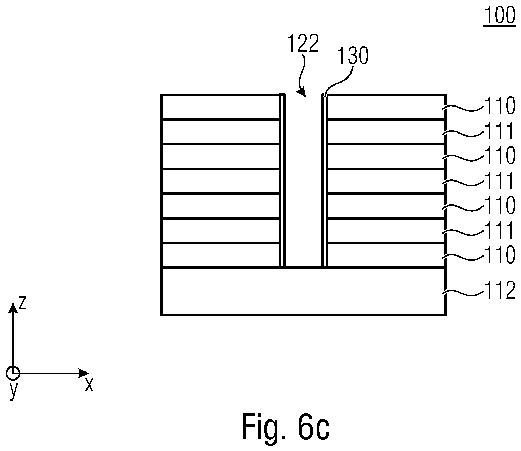

Fig. 6c shows a schematic cross sectional view of the three-dimensional memory device 100 after the step of forming a second insulating layer 130 on sidewalls of the of the channel opening 122.

For example, the second insulating layer 130 can comprise or consist of SiO2 (silicon dioxide), Al2O3 (aluminum oxide), high K or ONO (oxide-nitride-oxide). For example, high k dielectrics can be used as blocking layer to enhance information storage. For example, the second insulating layer 130 can have a thickness of 5nm. There could be a thin film of silicon oxide.

For example, the second insulating layer 130 can be formed by means of a deposition technique, such as CVD (chemical vapor deposition) or ALD (atomic layer deposition).

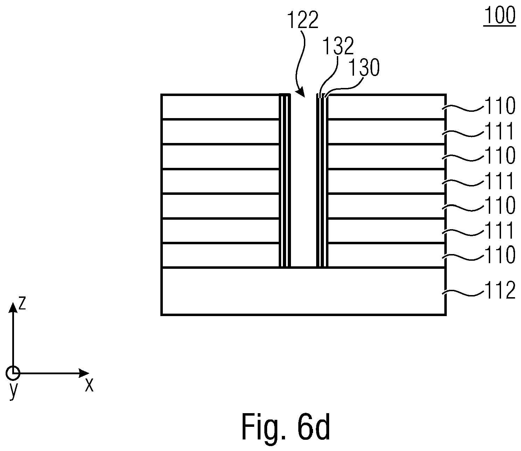

Fig. 6d shows a schematic cross sectional view of the three-dimensional memory device 100 after a step of forming an information storage 132 layer on the second insulating layer 130.

For example, the information storage 132 layer can be a charge trap layer. For example, the information storage layer 132 can comprise or consist of silicon nitride, such as Si3N4, which, for example, traps electric charges, stores electrons and prevents cell to cell interference.

For example, the information storage 132 layer can be formed by means of a deposition technique, such as CVD (chemical vapor deposition) or ALD (atomic layer deposition).

Fig, 6e shows a schematic cross sectional view of the three-dimensional memory device 100 after a step of forming the first insulating layer 134 on the information storage layer.

For example, the first insulating layer 134 can be a blocking insulating layer. For example, the first insulating layer 134 can comprise or consist of SiO2 (silicon dioxide), Al2O3 (aluminum oxide), high K, ONO (oxide-nitride-oxide) or Si2N20 (silicon oxinitride). For example, the first insulating layer 134 can have a thickness of approx. 7nm. The first insulating layer 134 is a dielectric insulating layer that prevents data corruption.

For example, the first insulating layer 134 can be formed by means of a deposition technique, such as CVD (chemical vapor deposition) or ALD (atomic layer deposition).

The first insulating layer 134, the information storage layer 132, and the second insulating layer 130 can form an information storage/memory layer stack.

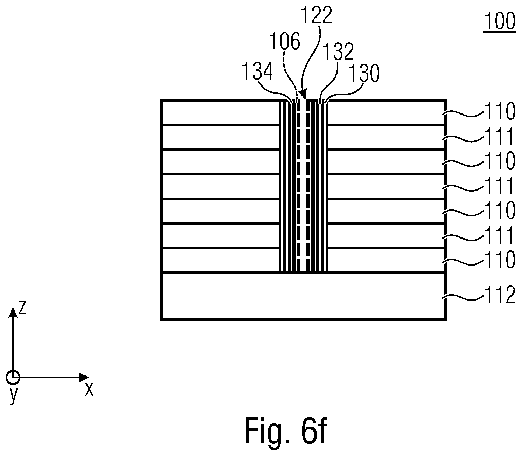

Fig. 6f shows a schematic cross sectional view of the three-dimensional memory device 100 after the step 208 of forming a first (e.g., vertical) layer 106 of a semiconductor material on the first insulating layer 134.

In embodiments, the first layer 106 can comprise or consist of Si or poly Si.

In embodiments, the first layer 106 can be formed directly on the first insulating layer 134.

In embodiments, the first layer 106 can be formed by means of a deposition technique, such as CVD (chemical vapor deposition) or ALD (atomic layer deposition).

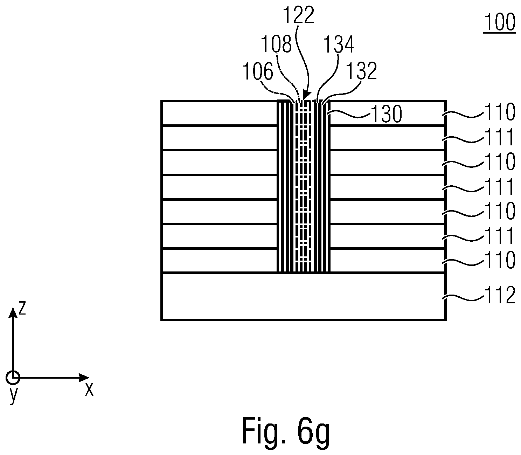

Fig. 6g shows a schematic cross sectional view of the three-dimensional memory device 100 after the step 210 of forming a (e.g., vertical) second layer 108 on the first layer 106, wherein the second layer 108 is adapted to apply a mechanical stress (e.g., tensile strain) on the first layer 106.

In embodiments, the second layer 108 can comprise or consist of SiGe (silicon germanium).

In embodiments, the second layer 108 can be formed by means of a deposition technique, such as CVD (chemical vapor deposition) or ALD (atomic layer deposition).

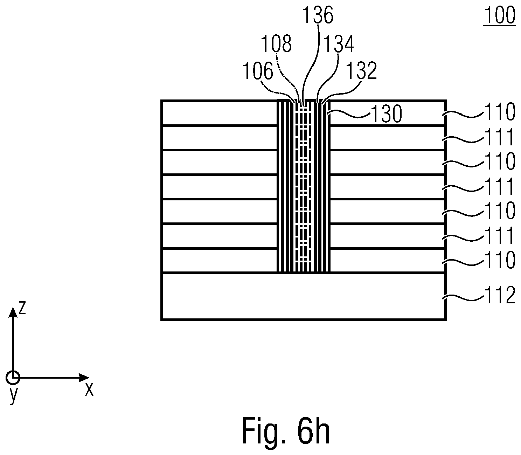

Fig. 6h shows a schematic cross sectional view of the three-dimensional memory device 100 after a step of filling the channel opening with an isolating material 136.

Afterwards, the gate layer can be formed similarly as described above with reference to Figs. 5k to 5m. Thereby, the gate layer can comprise or consist of a metal, such tungsten, e.g., having a thickness of approx. 3 µm (e.g., in a lateral direction).

The above described embodiments are merely illustrative for the principles of the present invention. It is understood that modifications and variations of the arrangements and the details described herein will be apparent to others skilled in the art. It is the intent, therefore, to be limited only by the scope of the impending patent claims and not by the specific details presented by way of description and explanation of the embodiments herein.

### Cited References

[1] Whitepaper, "Considerations for Improving 3D NAND Performance, Reliability, and Yield", Entegris 2018
[2] Samsung V-NAND Process description from "SP18422 - MEMORY - Leading-edge 3D NAND Memories Comparison 2018"
[3] Nebrich et al., "Process integration of infrared-sensitive PIN photodiodes and CMOS transistors in a single-SiGe substrate", Material Science in Semiconductor Processing 8 (2005) 429-433
[4] US 8,728,893 B2
[5] US 2016/0027796 A1
[6] US 2016/0133638 A1

## Claims

1. A three-dimensional semiconductor memory device (100), comprising:
a plurality of stacked memory cells (102),
wherein the plurality of stacked memory cells (102) comprise a common channel (104),
wherein the channel (104) comprises a first layer (106) of a semiconductor material and a second layer (108) formed on the first layer (106), wherein the second layer (108) is adapted to apply a mechanical stress on the first layer (106).

2. The three-dimensional semiconductor memory device (100) according to claim 1,
wherein the first layer (106) of the channel (108) is formed on an insulating layer (134) of the stacked memory cells (102).

3. The three-dimensional semiconductor memory device (100) according to one of the claims 1 and 2,
wherein the second layer (108) is directly formed and mechanically connected to the first layer (106).

4. The three-dimensional semiconductor memory device (100) according to one of the claims 1 to 3,
wherein the first layer (106) comprises silicon, Si.

5. The three-dimensional semiconductor memory device (100) according to claim 4,
wherein the second layer (108) is a silicon compatible layer.

6. The three-dimensional semiconductor memory device (100) according to one of the claims 4 and 5,
wherein the second layer (108) comprises silicon-germanium, SiGe.

7. The three-dimensional semiconductor memory device (100) according to one of the claims 1 to 6,
wherein the three-dimensional semiconductor memory device (100) is a three-dimensional NAND memory device.

8. A method (200) for manufacturing a three-dimensional semiconductor memory device, the method (200) comprising:
providing (202) a memory device layer stack (120) comprising a semiconductor substrate (112), sacrificial layers (111) and dielectric layers (110), wherein the sacrificial layers (111) and the dielectric layers (110) are alternately and repeatedly stacked on the semiconductor substrate (112),
patterning the sacrificial layers (111) and the dielectric layers to form at least one channel opening (122),
forming at least an insulating layer (134) in the channel opening (122),
forming a first layer (106) of a semiconductor material on the insulating layer (134),
forming a second layer (108) on the first layer (106), wherein the second layer (108) is adapted to apply a mechanical stress on the first layer (106).

9. The method (200) for manufacturing according to claim 8,
wherein the first layer (106) is formed on the insulating layer (134) by means of a deposition technique,
and/or wherein the second layer (108) is formed on the first layer (106) by means of a deposition technique.

10. The method (200) for manufacturing according to one of the claims 8 and 9,
wherein forming at least an insulating layer (134) in the channel opening includes forming an information storage layer stack (130, 132, 134) in the channel opening, the information layer stack comprising the insulating layer (134).

11. The method (200) for manufacturing according to claim 10,
wherein the insulating layer (134) is a first insulating layer,
wherein the information storage layer stack (130, 132, 134) is formed by:
selectively removing portions of the sacrificial layers (111) while maintaining the dielectric layers (110), to form recesses (124),
forming a second insulating layer (130) in the recesses (124),
forming an information storage layer (132) on the second insulating layer (130),
forming the first insulating layer (134) on the information storage layer (132).

12. The method (200) for manufacturing according to one of the claims 10 and 11, wherein the method (200) further comprises:
patterning the sacrificial layers (111) and the insulating layers (110) to form trenches (140),
selectively removing the sacrificial layers (111) while maintaining the dielectric layers (110), to form recesses (142) exposing some portions of the information storage layer stack,
forming a gate layer (144) in the recesses (142), such that the gate layer (144) contacts the information storage layer stack.

13. The method (200) for manufacturing according to one of the claims 8 and 9,
wherein forming at least an insulating layer (134) in the channel opening (122) comprises forming the insulating layer (134) on the sidewalls of the channel opening, or wherein forming at least an insulating layer (134) in the channel comprises forming an information storage layer stack (130, 132, 134) on sidewalls of the channel opening (122), the information layer stack (130, 132, 134) comprising the insulating layer (134).

14. The method (200) for manufacturing according to claim 13,
wherein the insulating layer (134) is a first insulating layer,
wherein the method (200) further comprises:
forming a second insulating layer (130) on sidewalls of the of the channel opening (122),
forming an information storage layer (132) on the second insulating layer (130),
forming the first insulating layer (134) on the information storage layer (132).

15. The method (200) according to claim 14, wherein the method (200) further comprises:
patterning the sacrificial layers (111) and the dielectric layers (110) to form trenches (140),
selectively removing the sacrificial layers (111) while maintaining the dielectric layers (110), to form recesses (142) exposing some portions of the information storage layer stack,
forming a gate layer (144) in the recesses (142), such that the gate layer (144) contacts the information storage layer stack.

16. The method (200) for manufacturing according to one of the preceding claims, wherein the method (200) further comprises:
filling the channel opening (122) after forming the first layer (106) and the second layer (108) with an isolating material (136).
